# EUROPEAN PATENT APPLICATION

(11) **EP 4 611 170 A1**
(43) Date of publication of application: **03.09.2025**
(21) Application number: 25161297.4
(22) Date of filing: 03.03.2025
(51) Int. Cl.: H01Q 1/24, H01Q 9/28, H01Q 21/26, H01Q 25/00

(54) **LOW-COST DUAL-POLARIZED RADIATING ELEMENTS AND RELATED BASE STATION ANTENNAS**

(30) Priority: 01.03.2024 CN 202410235579
(71) Applicant: Outdoor Wireless Networks LLC, Claremont, NC 28610 (US)
(72) Inventor: Zhang, Jian, Suzhou, 215021 (CN); Sun, Bin, Suzhou, 215021 (CN); Xue, Cheng, Suzhou, 215021 (CN); Chen, Changfu, Suzhou, 215021 (CN); Guo, Pengfei, Suzhou, 215021 (CN); Li, Haifeng, Suzhou, 215021 (CN)
(74) Representative: Meissner Bolte Partnerschaft mbB

(57) **Abstract**

Radiating elements comprise a dielectric support, first through fourth sheet metal dipole arms on the dielectric support, and a feed stalk printed circuit board. The feed stalk printed circuit board includes a first RF transmission line that has a first signal conductor that is coupled to the first sheet metal dipole arm through at least a first capacitive connection and a first ground conductor that is coupled to the second sheet metal dipole arm through at least a second capacitive connection and a second RF transmission line that has a second signal conductor that is coupled to the third sheet metal dipole arm through at least a third capacitive connection and a second ground conductor that is coupled to the fourth sheet metal dipole arm through at least a fourth capacitive connection.

## Description

### CROSS-REFERENCE TO RELATED APPLICATIONS

The present application claims priority to Chinese Patent Application No. 2024102355793, filed March 1, 2024, the entire content of each of which is incorporated herein by reference.

### FIELD

The present invention generally relates to radio communications and, more particularly, to base station antennas for cellular communications systems and to radiating elements for such base station antennas.

### BACKGROUND

Cellular communications systems are well known in the art. In a cellular communications system, a geographic area is divided into a series of regions that are referred to as "cells" which are served by respective base stations. Each base station includes baseband equipment, radios and base station antennas that are configured to provide two-way radio frequency ("RF") communications with subscribers that are positioned throughout the cell served by the base station. The base station antennas are often mounted on a tower or other raised structure, with the radiation pattern ("antenna beam") that is generated by each antenna directed outwardly to serve a respective sector. Typically, a base station antenna includes multiple phase-controlled arrays of radiating elements, with the radiating elements arranged in vertically-extending columns that are referred to as "linear arrays." Herein, "vertical" refers to a direction that is generally perpendicular relative to the plane defined by the horizon. References will also be made herein to the "azimuth" plane, which refers to a horizontal plane that bisects the base station antenna that is parallel to the plane defined by the horizon.

Most cells are divided into a plurality of "sectors," and separate base station antennas provide coverage (service) to each of the sectors. The most common base station configuration is the so-called "three sector configuration" in which a cell is divided into three 120° "sectors" in the azimuth plane. In a three sector configuration, the antenna beams generated by the linear arrays typically have half power beamwidths in the azimuth plane ("azimuth HPBW") of about 65° (i.e., the angle subtended in the azimuth plane by the portion of the antenna beam that has a gain that is within 3 dB of the peak gain is about 65°). Generally speaking, an antenna beam having an azimuth HPBW of about 65° will provide reasonably good coverage throughout a 120° sector without having excessive spillover of RF energy into adjacent sectors. Such spillover of RF energy into adjacent cells is undesirable both because it reduces the gain of the antenna beam within the sector and because the spillover appears as interference to the antenna beams in the adjacent sectors.

Typically, each base station antenna will include multiple linear arrays of radiating elements that operate, for example, using second generation ("2G"), third generation ("3G") or fourth generation ("4G") cellular network protocols. The linear arrays may be "perfect" columns of radiating elements where all of the radiating elements are aligned along a vertically-extending axis, or may be "staggered" columns in which some of the radiating elements are staggered horizontally (and may even be aligned with an adjacent column of radiating elements) in order to reduce (narrow) the azimuth HPBW of the antenna beams generated by the linear arrays. Most modern base station antennas include both "low-band" linear arrays of radiating elements that support service in some or all of the 617-960 MHz frequency band and "mid-band" linear arrays of radiating elements that support service in some or all of the 1427-2690 MHz frequency band. These linear arrays are typically formed using dual-polarized radiating elements, which allows each linear array to transmit and receive RF signals at two orthogonal polarizations.

The radiating elements of each of the above-described linear arrays are coupled to two ports of a radio (one port for each polarization). An RF signal that is to be transmitted by a linear array is passed from the radio port to the antenna where it is divided into a plurality of sub-components, with each sub-component fed to a respective subset of the radiating elements in the linear array (typically each sub-component is fed to between one and three radiating elements). The sub-components of the RF signal are transmitted through the radiating elements to generate an antenna beam that covers a generally fixed coverage area, such as a sector of a cell. Since the antenna beams generated by the above-described 2G/3G/4G linear arrays generate fixed (static) antenna beams, they are often referred to as "passive" linear arrays.

Most cellular operators are currently upgrading their networks to support fifth generation ("5G") cellular service. One important component of 5G cellular service is the use of so-called "active" beamforming arrays that operate in conjunction with "active" beamforming radios to dynamically adjust the size, shape and pointing direction of the antenna beams that are generated by the active beamforming array. Active beamforming arrays are typically formed using "high-band" radiating elements that operate in higher frequency bands, such as some or all of the 3.1-4.2 GHz and/or the 5.1-5.8 GHz frequency bands, although active beamforming arrays may also be provided that operate in the upper portion of the mid-band frequency range (e.g., 2300-2690 MHz). Many modern base station antennas include both passive low-band and mid-band linear arrays plus one or more 5G beamforming arrays. Moreover, in order to support higher order multi-input-multi-output ("MIMO") communication techniques (e.g., 4xMIMO or 8xMIMO) and/or to provide service in multiple sub-bands of the mid-band frequency range, many base station antennas include multiple (e.g., two or four) low-band and/or mid-band linear arrays.

In order to fit larger numbers of arrays in a base station antenna, the radiating elements of the mid-band and/or high-band arrays are often mounted behind the radiating elements of the low-band linear arrays. Unfortunately, the low-band radiating elements can cause scattering of the RF energy emitted by the higher frequency band (mid-band or high-band) radiating elements. Scattering is undesirable as it changes the shape of the antenna beams generated by the higher frequency band array in both the azimuth and elevation planes. Scattering tends to increase the azimuth and elevation beamwidths of the higher frequency band antenna beams, which acts to reduce the gain, degrade the front-to-back ratio, and/or increase the interference that the antenna beams generate in neighboring sectors.

The scattering may occur because conductive structures of the low-band radiating elements can reflect RF energy transmitted by the higher frequency band radiating elements, causing the higher band RF energy to exit the base station antenna in undesired directions and/or in a desired direction but with a phase that causes the reflected RF energy to destructively combine with non-reflected RF energy. Scattering may also occur because certain conductive structure of the low-band radiating elements may have electrical lengths that make the structure resonant in the operating frequency band of the higher frequency band array, which may occur if the conductive structure has an electrical length that is about ½ a wavelength or about a full wavelength of a frequency within the operating frequency band of the higher frequency band array. Since the mid-band operating frequency range includes frequencies that are twice certain frequencies in the low-band operating frequency range, and the high-band operating frequency range includes frequencies that are four times certain frequencies in the low-band operating frequency range, the dipole arms of the low-band radiating elements - which typically have an electrical length of about ¼ of a center wavelength of the low-band operating frequency range - are typically resonant in at least portions of both the mid-band and high-band operating frequency ranges. When the low-band dipole arms are resonant in either the mid-band or the high-band, RF energy transmitted by the higher frequency band array may couple to the dipole arms of nearby low-band radiating elements and then re-radiate therefrom, resulting again in the higher frequency band RF exiting the base station antenna in undesired directions and/or to destructively combining with other RF energy emitted by the higher frequency band array.

"Cloaking" dipole radiating elements are known in the art that have dipole arms that are designed so that currents will largely not form thereon in response to RF radiation in preselected frequency ranges (e.g., currents in the operating frequency band of the high-band radiating elements in the 5G beamforming array). These radiating elements can reduce or eliminate the second of the above-described types of scattering of higher frequency band radiation by the dipole arms of nearby lower frequency band radiating elements.

While there is commercial interest in base station antennas that have many different arrays of radiating elements, cost is a major concern for cellular network operators and hence cellular network operators may not always deploy base station antennas that maximize performance in order to reduce cost. In addition, cellular network operators also often have strict limits on the widths of various types of base station antennas. Base station antennas are often mounted on antenna towers hundreds of feet above the ground and can be subject to very high wind levels. As a base station antenna is made wider, the wind loading increases, requiring that the base station antenna, its mounting hardware, and the antenna tower itself have increased structural durability. Thus, as the number of arrays included in a base station antenna is increased, the spacing between the arrays typically must be decreased to keep the width of the antenna within cellular network operator specified limits. Unfortunately, as the spacing between arrays is decreased, the adjacent arrays tend to interact with each other in undesirable ways, which can degrade the performance of the base station antenna. Thus, there is a need for low cost base station antennas that support a wide variety of services while also fitting within cellular network operator expectations for the width of the base station antenna.

### SUMMARY

Pursuant to some embodiments of the present invention, radiating elements that are suitable for use in base station antennas are provided that comprise a dielectric support, first through fourth sheet metal dipole arms on the dielectric support, and a feed stalk printed circuit board. The feed stalk printed circuit board includes a first RF transmission line that has a first signal conductor that is coupled to the first sheet metal dipole arm through at least a first capacitive connection and a first ground conductor that is coupled to the second sheet metal dipole arm through at least a second capacitive connection and a second RF transmission line that has a second signal conductor that is coupled to the third sheet metal dipole arm through at least a third capacitive connection and a second ground conductor that is coupled to the fourth sheet metal dipole arm through at least a fourth capacitive connection.

In some embodiments, the radiating element may further comprise a coupling printed circuit board that is mounted on the feed stalk printed circuit board. The coupling printed circuit board may include a first metal pad that is electrically connected to the first signal conductor through a first galvanic connection, a second metal pad that is electrically connected to the first ground conductor through a second galvanic connection, a third metal pad that is electrically connected to the second signal conductor through a third galvanic connection, and a fourth metal pad that is electrically connected to the second ground conductor through a fourth galvanic connection. In some embodiments, the first metal pad is capacitively coupled to the first sheet metal dipole arm, the second metal pad is capacitively coupled to the second sheet metal dipole arm, the third metal pad is capacitively coupled to the third sheet metal dipole arm, and the fourth metal pad is capacitively coupled to the fourth sheet metal dipole arm. In some embodiments, a base of the feed stalk printed circuit board that is remote from the dipole arms is positioned rearwardly of the first through fourth sheet metal dipole arms and the coupling printed circuit board is positioned forwardly of the first through fourth sheet metal dipole arms. In some embodiments, the first through fourth sheet metal dipole arms are positioned in between the dielectric support and the coupling printed circuit board. In some embodiments, the first through fourth metal pads are on a forward surface of a dielectric substrate of the coupling printed circuit board.

In some embodiments, the first ground conductor may include a first meandered trace segment and the second ground conductor includes a second meandered trace segment. In some embodiments, the first meandered trace segment and the second capacitive connection together form a first capacitor-inductor circuit that increases an impedance of the first RF transmission line, and the second meandered trace segment and the fourth capacitive connection together form a second capacitor-inductor circuit that increases an impedance of the second RF transmission line.

In some embodiments, a distal end of the feed stalk printed circuit board that is opposite the base may extend through a slot in the coupling printed circuit board.

In some embodiments, each of the first through fourth sheet metal dipole arms may be positioned adjacent two other of the first through fourth sheet metal dipole arms so that together the first through fourth sheet metal dipole arms form a radiating surface that has a square perimeter. In such embodiments, the feed stalk printed circuit board extends through an opening in the center of the radiating surface.

In some embodiments, the first signal conductor may be coupled to the first sheet metal dipole arm through both a solder joint and the first capacitive connection.

In some embodiments, the first sheet metal dipole arm includes a first tab that extends parallel to the feed stalk printed circuit board and is configured to capacitively couple with the first signal conductor to form the first capacitive connection, the second sheet metal dipole arm includes a second tab that extends parallel to the feed stalk printed circuit board and is configured to capacitively couple with the first ground conductor to form the second capacitive connection, the third sheet metal dipole arm includes a third tab that extends parallel to the feed stalk printed circuit board and is configured to capacitively couple with the second signal conductor to form the third capacitive connection, and the fourth sheet metal dipole arm includes a fourth tab that extends parallel to the feed stalk printed circuit board and is configured to capacitively couple with the second ground conductor to form the fourth capacitive connection. In such embodiments, the radiating element may further comprise a first solder mask on a first side of the feed stalk printed circuit board that is positioned between the first tab and the first signal conductor and a second solder mask on a second side of the feed stalk printed circuit board that is positioned between the second tab and the first ground conductor. In some embodiments, one of the first and second solder masks may also be positioned between the third tab and the second signal conductor and the other of the first and second solder masks is positioned between the fourth tab and the second ground conductor.

Pursuant to some embodiments of the present invention, radiating elements that are suitable for use in base station antennas are provided that comprise a plurality of sheet metal dipole arms, a feed stalk printed circuit board, and a coupling printed circuit board that is mounted on the feed stalk printed circuit board and configured to capacitively couple RF signals between the feed stalk printed circuit board and the sheet metal dipole arms.

In some embodiments, a base of the feed stalk printed circuit board is positioned rearwardly of the dipole arms and the coupling printed circuit board is positioned forwardly of the dipole arms.

In some embodiments, the first and second conductors of a first RF transmission line of the feed stalk printed circuit board are galvanically connected to respective first and second metal pads on the coupling printed circuit board.

In some embodiments, the first and second metal pads are on a forward surface of a dielectric substrate of the coupling printed circuit board.

In some embodiments, the first RF transmission line of the feed stalk printed circuit board includes a meandered trace segment. In such embodiments, the meandered trace segment and a capacitive connection between the first metal pad on the coupling printed circuit board and a first of the dipole arms may together form a capacitor-inductor circuit that increases an impedance of the first RF transmission line.

In some embodiments, the feed stalk printed circuit board comprises a first RF transmission line that is coupled to first and second of the sheet metal dipole arms and a second RF transmission line that is coupled to third and fourth of the sheet metal dipole arms.

In some embodiments, the coupling printed circuit board includes a first metal pad that is galvanically connected to a signal conductor of the first RF transmission line, a second metal pad that is galvanically connected to a ground conductor of the first RF transmission line, a third metal pad that is galvanically connected to a signal conductor of the second RF transmission line, and a fourth metal pad that is galvanically connected to a ground conductor of the second RF transmission line.

In some embodiments, the plurality of sheet metal dipole arms comprises first through fourth sheet metal dipole arms, and the first through fourth metal pads are capacitively coupled to respective ones of first through fourth sheet metal dipole arms.

In some embodiments, the feed stalk printed circuit board includes at least one tab that extends through a slot in the coupling printed circuit board.

Pursuant to still further embodiments of the present invention, radiating elements that are suitable for use in base station antennas are provided that comprise a dielectric support, a first sheet metal dipole arm on the dielectric support, a second sheet metal dipole arm on the dielectric support, and a feed stalk printed circuit board that includes a first RF transmission line that includes a first signal conductor and a first ground conductor. The first sheet metal dipole arm includes a first tab that is configured to capacitively couple with the first signal conductor and the second sheet metal dipole arm includes a second tab is configured to capacitively couple with the first ground conductor.

In some embodiments, the first and second tabs extend parallel to the feed stalk printed circuit board.

In some embodiments, the radiating element may further comprise a first solder mask on a first side of the feed stalk printed circuit board that is positioned between the first tab and the first signal conductor and a second solder mask on a second side of the feed stalk printed circuit board that is positioned between the second tab and the first ground conductor.

In some embodiments, the feed stalk printed circuit board further comprises a second RF transmission line that includes a second signal conductor and a second ground conductor, and the radiating element further comprises a third sheet metal dipole arm and a fourth sheet metal dipole arm.

In some embodiments, the third sheet metal dipole arm includes a third tab that extends parallel to the feed stalk printed circuit board and is configured to capacitively couple with the second signal conductor and the fourth sheet metal dipole arm includes a fourth tab that extends parallel to the feed stalk printed circuit board and is configured to capacitively couple with the second ground conductor.

In some embodiments, the first solder mask is also positioned between the third tab and the second signal conductor and the second solder mask is positioned between the fourth tab and the second ground conductor.

In some embodiments, the first RF transmission line includes a meandered trace segment. In some embodiments, the meandered trace segment and a capacitive connection between the first pad and the first signal conductor together form a capacitor-inductor circuit that increases an impedance of the first RF transmission line.

### BRIEF DESCRIPTION OF THE DRAWINGS

**FIG. 1** is an exploded front perspective view of a conventional low-band radiating element.
**FIG. 2A** is a perspective view of a conventional multiband base station antenna.
**FIG. 2B** is a schematic front view of the conventional base station antenna of **FIG. 2A** with the radome removed that illustrates an antenna assembly of the antenna.
**FIG. 3A** is a front perspective view of a low-band radiating element according to embodiments of the present invention.
**FIG. 3B** is a side view illustrating a first major surface of the feed stalk printed circuit board included in the radiating element of **FIG. 3A****.**
**FIG. 3C** is a side view illustrating a second major surface of the feed stalk printed circuit board included in the radiating element of **FIG. 3A****.**
**FIG. 3D** is a front view of the four dipole arms included in the radiating element of **FIG. 3A****.**
**FIG. 3E** is a front view illustrating a first major surface of a coupling printed circuit board included in the radiating element of **FIG. 3A****.**
**FIGS. 4A-4C** are front views illustrating first major surfaces of three alternative coupling printed circuit boards that may be used in place of the coupling printed circuit board of **FIG. 3E** in the radiating element **of** **FIG. 3A****.**
**FIG. 4D** is a shadow front view of another alternative coupling printed circuit board that may be used in place of the coupling printed circuit board of **FIG. 3E** in the radiating element of **FIG. 3A****.**
**FIG. 5A** is a front perspective view of a low-band radiating element according to further embodiments of the present invention.
**FIG. 5B** is an enlarged perspective front view of the electrical connections between the feed stalk printed circuit board and dipole arms of the low-band radiating element of **FIG. 5A****.**

### DETAILED DESCRIPTION

The size of a radiating element is generally inversely-correlated with frequency and therefore the low-band radiating elements are typically the largest radiating elements in a base station antenna. Most cellular operators prefer base station antennas that include at least two low-band linear arrays (to support 4xMIMO communications) because low-band RF signals pass more readily through physical obstacles such as trees, buildings, hills, etc. than do mid-band and high-band RF signals.

Conventional low-band radiating elements typically have a "footprint" of nearly 140 mm x 140 mm, where the footprint refers to the size of the radiating element when viewed from the front. Since two linear arrays of low-band radiating elements need to be spaced apart from each other by some distance (e.g., at least 215 mm center-to-center) and since the low-band radiating elements also need to be inset from the sides of the base station antenna, the large physical size of conventional low-band radiating elements made it difficult to fabricate base station antennas that include two low-band linear arrays that had widths of less than 450 mm. PCT Patent Publication No. WO 2023/192929 ("the '929 publication") discloses several low-band radiating element designs where the radiating elements have a footprint of less than 130 mm x 130 mm. Using the smaller low-band radiating elements of the '929 publication, base station antennas can be provided that have two linear arrays of low-band radiating elements where the width of the base station antenna is less than 400 mm.

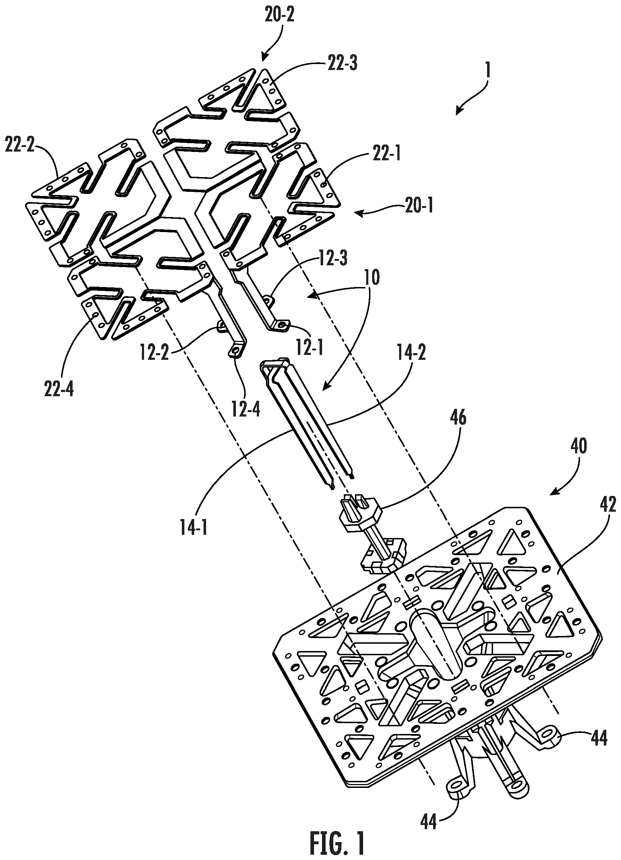

**FIG. 1** is an exploded perspective view of the small footprint low-band radiating element **1** that is disclosed in the '929 publication. As shown in **FIG. 1****,** the radiating element **1** is a so-called cross-dipole radiating element that includes first and second dipole radiators **20-1, 20-2** that are perpendicular to each other. The dipole radiators **20** are arranged so that the first dipole radiator **20-1** extends at an angle of -45° with respect to a longitudinal axis of a base station antenna that includes radiating element **1,** while the second dipole radiator **20-2** extends at an angle of +45° with respect to a longitudinal axis of the base station antenna. Thus, the first dipole radiator **20-1** will emit RF radiation having a linear slant -45° polarization, while the second dipole radiator **20-2** will emit RF radiation having a linear slant +45° polarization. These two polarizations are orthogonal to each other and hence radiating element **1** can simultaneously transmit/receive two RF signals at the same frequency because of the inherent isolation between the two polarizations. It should be noted that herein like elements may be referred to individually by their full reference numeral (e.g., second dipole radiator **20-2)** and may be referred to collectively by the first part of their reference numeral (e.g., the dipole radiators **20).**

The first dipole radiator **20-1** comprises first and second dipole arms **22-1, 22-2,** while the second dipole radiator **20-2** comprises third and fourth dipole arms **22-3, 22-4.** Radiating element **1** further includes a feed stalk **10** in the form of first through fourth dipole legs **12-1** through **12-4,** which are electrically connected to the respective first through fourth dipole arms **22-1** through **22-4.** Each dipole leg **12** and its associated dipole arm **22** are formed as an integral (monolithic) element by stamping the element from sheet metal and then bending the stamped sheet metal into the shape shown in **FIG. 1****.** The dipole legs **12** are typically mounted on a reflector of a base station antenna (or on a feed board printed circuit board that is mounted on the reflector) and extend generally perpendicularly to the dipole arms **22.** Consequently, the dipole legs **12** may mount the dipole arms **22** forwardly of the reflector and extending generally parallel to the reflector.

Radiating element **1** may be connected to first and second RF transmission lines of respective first and second feed networks of the base station antenna in which radiating element **1** is used. Most typically, the first and second RF transmission lines of these feed networks are provided on a feed board printed circuit board that the radiating element **1** is mounted on. However, other implementations are possible (e.g., radiating element **1** may be directly fed by first and second coaxial cables that form the first and second RF transmission lines). The ground conductor of the first RF transmission line may be connected to the first and second dipole legs **12-1, 12-2,** and the ground conductor of the second RF transmission line may be connected to the third and fourth dipole legs **12-3, 12-4.**

The feed stalk **10** further includes first and second feed lines **14-1, 14-2** that feed the respective first and second dipole radiators **20-1, 20-2.** Each feed line **14** includes a base that is adjacent the reflector of the base station antenna and that connects to a respective one of the first and second RF transmission lines (i.e., to the feed networks). Each feed line **14** also has a distal end that is adjacent the dipole arms **22.** Each feed line **14** is formed of stamped and bent sheet metal, and takes the form of a respective hook-balun. As is well known in the art, a hook-balun feed line may be used to capacitively feed the two dipole arms that form a dipole radiator. The dipole legs **12** define a rectangular cylinder and the feed lines **14** extend through this rectangular cylinder so that the dipole legs **12** surround the feed lines **14.** The forwardly and rearwardly portions of the hook-balun feed lines **14** extend parallel to the dipole legs **12** and perpendicularly to the dipole arms **22.** Each of the first through fourth dipole arms **22** is positioned adjacent two other of the first through fourth dipole arms **22** to form a radiating surface **24** that has a square perimeter when viewed from the front. Each dipole arm **22** may have a perimeter that generally defines a square, except that one corner of the perimeter is truncated so that an opening **26** is provided in the middle of the radiating surface **24.** The distal ends of the feed lines **14** are mounted through or behind this opening **26.**

The dipole arms **22** are mounted on a dielectric support **40.** The dielectric support **40** includes a forward supporting surface **42** that has a substantially square outer contour. The four dipole arms **22-1** through **22-4** are mounted on and supported by the forward supporting surface **42** of dielectric support **40** and may be attached to the dielectric support **40** using fastening elements such as rivets or a dielectric cover. The dielectric support **40** further includes a plurality of rearwardly extending legs **44** that may be mounted, for example, on a reflector of a base station antenna. A separate dielectric feed line support **46** is provided that mounts the feed lines **14** in the rectangular cylinder defined by the dipole legs **12.**

Still referring to **FIG. 1****,** each sheet metal dipole arm **22** has an outer contour that generally has a square shape, and the four sheet metal dipole arms **22-1** through **22-4** are positioned next to each other so that the outer contour of the combination of all four dipole arms **22-1** through **22-4** defines a larger radiating surface that has a generally square outer perimeter. The first and second inner sides of each dipole arm **22** are adjacent inner sides of two others of the dipole arms **22.** Adjacent dipole arms **22** are separated by a small gap so that the larger radiating surface defined by the combination of all four dipole arms **22** is more than four times larger than the smaller squares defined by the individual dipole arms **22.**

Each dipole arm **22** includes a plurality of wide sections **30** and a plurality of narrowed sections **32,** in which, every two adjacent wide sections **30** are connected through a narrowed section **32.** The widened sections **30** may capacitively couple with each other and the narrowed sections **32** may add inductance so that the dipole arms **22** may have embedded inductor-capacitor ("LC") circuits that may be tuned to pass lower frequency band currents while blocking higher frequency band currents. As a result, the dipole arms **22** may readily transmit and receive RF signals in the low-band operating frequency range while being substantially transparent to RF energy in the mid-band and/or high-band operating frequency ranges. In other words, the low-band radiating element **1** may be cloaked with respect to mid-band and/or high-band RF radiation so that such radiation will not induce substantial currents on the low-band dipole arms **22.**

As discussed in the '929 publication, the radiating element **1** may be designed to operate on the 696-960 MHz frequency band and may have a footprint of only 126 mm x 126 mm, which is significantly smaller than most other conventional low-band radiating elements. This may allow the width of a base station antenna that includes two linear arrays of low-band radiating elements to be reduced. In addition, since the size of the low-band radiating element **1** is reduced in both the horizontal and vertical directions, the low-band radiating element **1** may have less overlap with the mid-band and/or high-band radiating elements when used in a multiband base station antenna, which can further improve the cloaking performance.

Pursuant to embodiments of the present invention, small low-band radiating elements are provided that may exhibit good cloaking performance and have reduced cost. The radiating elements **1** of the '929 publication may be less expensive than low-band radiating elements in which the dipole arms and feed stalks are formed on printed circuit boards, since sheet metal dipole arms and legs may be significantly cheaper than the relatively large printed circuit boards required to implement the dipole radiators and feed stalks of low-band radiating elements. However, conventional printed circuit board based radiating elements may have some advantages as compared to the sheet metal radiating elements **1** of the '929 publication in that printed circuit board based feed stalks may be easy to mount on the feed board printed circuit boards of a base station antenna, and also can be readily soldered to feed board printed circuit boards to electrically connect the RF transmission lines on the feed board printed circuit boards to corresponding RF transmission lines on the feed stalk printed circuit boards. The dipole legs **12** and feed lines **14** of the above-described sheet metal radiating element **1** of the '929 publication are also typically soldered to a feed board printed circuit board of a base station antenna. However, to ensure a good solder joint that will not introduce passive intermodulation distortion, a tin-based material is plated on the dipole arms and legs **12, 14** of the radiating element **1.** This tin plating process increases the cost of the radiating element **1.** In addition, the four dipole legs **12** and two hook balun feed lines **14** may comprise a significant amount of metal that may scatter RF radiation emitted by higher band radiating elements that are mounted rearwardly of the radiating elements **1** (i.e., the radiating element **1,** even though cloaked to suppress the second type of scattering discussed above, may still cause the first type of scattering). As discussed above, such scattering may degrade the shape, pointing direction, gain and other parameters of the antenna beams generated by arrays of higher band radiating elements that are mounted rearwardly of a linear array of low-band radiating elements **1.**

The radiating elements according to embodiments of the present invention may include inexpensive sheet metal based dipole arms that are fed by a printed circuit board based feed stalk. Each electrical connection between the feed stalk and the dipole arms may comprise a capacitive connection, which eliminates any need to solder the dipole arms to the feed stalk, thereby eliminating any need to plate a tin-based material on the sheet metal dipole arms. In addition, the feed stalks for the radiating elements according to embodiments of the present invention may be implemented using a single, relatively small feed stalk printed circuit board, which further reduces the cost of the radiating element and also reduces the extent to which the feed stalk scatters RF radiating emitted by nearby higher band radiating elements.

In some cases, the radiating elements according to embodiments of the present invention may include a small coupling printed circuit board that may be mounted, for example, forwardly of the dipole arms. In such embodiments, the feed stalk printed circuit board may extend through an opening in the radiating surface defined by the dipole arms so that the coupling printed circuit board may be mounted on the distal end of the feed stalk printed circuit board. The feed stalk printed circuit board may include one or more forwardly extending tabs that extend through corresponding slots in the coupling printed circuit board to mechanically mount the coupling printed circuit board on the feed stalk printed circuit board. Solder joints may be applied to improve the mechanical connection between the coupling printed circuit board and the feed stalk printed circuit board and to electrically connect the signal and ground conductors of first and second RF transmission lines on the on the feed stalk printed circuit board to four corresponding metal pads on the coupling printed circuit board. The four metal pads on the coupling printed circuit board may be capacitively coupled to respective ones of the four dipole arms. Thus, the signal and ground conductors of the RF transmission lines on the feed stalk printed circuit board may be coupled to the respective dipole arms through both a galvanic (solder joint) connection and a capacitive connection. The coupling printed circuit board may be very small, and hence may not materially add to the expense of the radiating element.

In other embodiments, the radiating elements may be designed so that the signal and ground conductors of first and second RF transmission lines on the feed stalk printed circuit board may be connected to respective ones of the four dipole arms through "direct" capacitive connections. In example embodiments, each sheet metal dipole arm may include a tab that is bent to extend substantially in parallel to the feed stalk printed circuit board, where each tab is positioned to horizontally overlap a respective one of the signal and ground conductors of the RF transmission lines on the feed stalk printed circuit board. One or more solder masks may be interposed between the tabs and the respective conductors so that each tab and its associated conductor forms a capacitor so that the signal and ground conductors of the RF transmission lines on the feed stalk printed circuit board are capacitively coupled to the respective dipole arms. Using such direct capacitive connections eliminates any need for a coupling printed circuit board, further reducing the cost of the radiating element.

The dipole arms of the radiating elements according to embodiments of the present invention may be cloaked dipole arms that are designed to suppress the formation of currents on the dipole arms in certain higher frequency bands. While the use of cloaking dipole arms may improve the performance of a multiband base station antenna, the cloaking design often increases the impedance of the dipole arms above 50 ohms such that the dipole arms may not have a good impedance match with the feed stalk printed circuit board (typically the RF lines on a feed stalk printed circuit board are designed as 50 ohm RF transmission lines in order to be impedance matched with the RF transmission lines of a feed network that feeds the feed stalks). The feed stalk printed circuit boards used in the radiating elements according to embodiments of the present invention may include inductive elements such as meandered traces that, in conjunction with the capacitive connections to the dipole arms, may form impedance matching circuits that better match the RF transmission lines on the feed stalk printed circuit board to the dipole arms, thereby expanding the operating bandwidth of the radiating elements.

Before discussing the radiating elements according to embodiments of the present invention it is helpful to discuss the design of an example conventional multiband base station antenna.

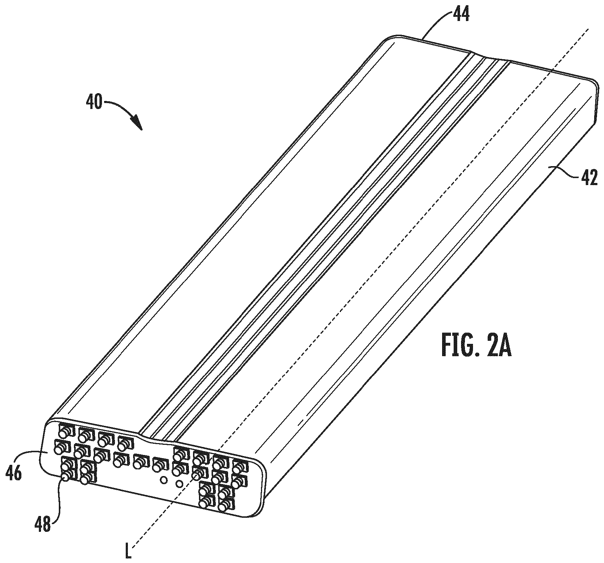

**FIG. 2A** is a schematic front view of a conventional multiband base station antenna **40.** In the description that follows, the base station antenna **40** and the radiating elements included therein will be described using terms that assume that the base station antenna **40** is mounted for normal use on a tower with a longitudinal axis of the base station antenna **40** extending along a vertical axis and the front surface of the base station antenna **40** mounted opposite the tower (or other mounting structure) so as to point toward the coverage area for the base station antenna **40.**

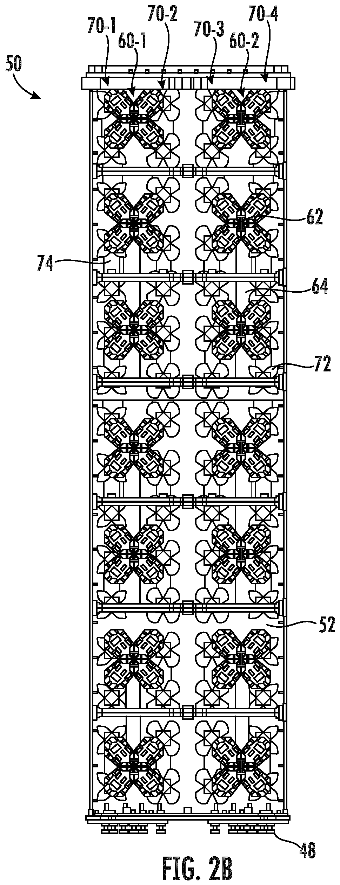

As shown in **FIG. 2A****,** the conventional base station antenna **40** is an elongated structure that extends along a longitudinal axis. The base station antenna **40** may have a tubular shape with a generally rectangular cross-section. The base station antenna **40** includes a tubular radome **42** and a top end cap **44.** The base station antenna **40** also includes a bottom end cap **46** which includes a plurality of RF ports **48** such as RF connectors mounted therein. The RF ports **48** extend through the bottom end cap **46.** The radome **42,** top cap **44** and bottom cap **46** may form an external housing for the antenna **40.** An antenna assembly **50 (****FIG. 2B****)** is contained within the external housing. The antenna assembly **50** may be slidably inserted into the radome **42** from either the top or bottom before the top end cap **44** or bottom end cap **46** are attached to the radome **42.**

**FIG. 2B** is a schematic perspective view of the antenna assembly **50** of base station antenna **40.** As shown in **FIG. 2B****,** the antenna assembly **50** includes a reflector **52** which may comprise a metallic surface (e.g., a sheet of aluminium) that reflects forwardly RF radiation that is emitted rearwardly by the radiating elements included in the base station antenna **40** and which also serves as a ground plane for the radiating elements. Various mechanical and electronic components of the antenna (not shown) may be mounted behind the reflector **52** such as, for example, phase shifters, remote electronic tilt units, mechanical linkages, controllers, diplexers, and the like.

A plurality of linear arrays of dual-polarized radiating elements are mounted to extend forwardly from the reflector **52.** The linear arrays include two low-band linear arrays **60-1, 60-2** that each comprise a respective vertically-extending column of low-band radiating elements **62,** and four mid-band linear arrays **70-1** through **70-4** that each comprise a respective vertically-extending column of mid-band radiating elements **72.** The base station antenna **40** is often referred to as a 2L4H antenna, reflecting that the antenna **40** includes two low-band linear arrays **60** and four higher-band (here mid-band) linear arrays **70.** The RF ports **48** are used to connect the linear arrays **60, 70** to one or more external radios (not shown).

In the depicted embodiment, the first low-band linear array **60-1** is positioned between the first and second mid-band linear arrays **70-1, 70-2,** and the second low-band linear array **60-2** is positioned between the third and fourth mid-band linear arrays **70-3, 70-4.** It will be appreciated that base station antenna **40** illustrates one typical layout of arrays of low-band and mid-band linear arrays **60, 70.** It will likewise be appreciated that the number and/or types of arrays may be varied from what is shown based on applications and/or customer requirements, as may the positioning of the linear arrays on the reflector **52** and/or the number of radiating elements included in each linear array. For example, the base station antenna **40** could alternatively include one or more planar arrays of high-band radiating elements that replace the second and third linear arrays **70-2, 70-3** of mid-band radiating elements **72.**

The low-band radiating elements **62** may be configured to transmit and receive signals in a first frequency band such as, for example, the 617-960 MHz frequency range or a portion thereof (and most typically, in the 696-960 MHz frequency band). The mid-band radiating elements **72** may be configured to transmit and receive signals in a second frequency band such as, for example, the 1427-2690 MHz frequency range or a portion thereof. In the depicted embodiment, the mid-band radiating elements in linear arrays **70-1** and **70-4** include mid-band radiating elements that are configured to transmit and receive RF signals in the 1695-2690 MHz frequency band, while the mid-band radiating elements in linear arrays **70-2** and **70-3** include mid-band radiating elements that are configured to transmit and receive RF signals in the 1427-2690 MHz frequency band. The radiating elements **62, 72** may be dual polarized radiating elements (e.g., -45°/+45° cross-dipole radiating elements), and hence each linear array **60, 70** may be used to form a pair of antenna beams, namely an antenna beam for each of the two polarizations at which the dual-polarized radiating elements **62, 72** are designed to transmit and receive RF signals. The radiating elements **62, 72** are mounted on feed board printed circuit boards (herein "feedboards") **64, 74** that couple RF signals to and from the individual radiating elements **62, 72.** One or more radiating elements **62, 72** may be mounted on each feedboard **64, 74.** Cables (not shown) may be used to connect each feed board printed circuit board to other components of the antenna such as diplexers, phase shifters or the like.

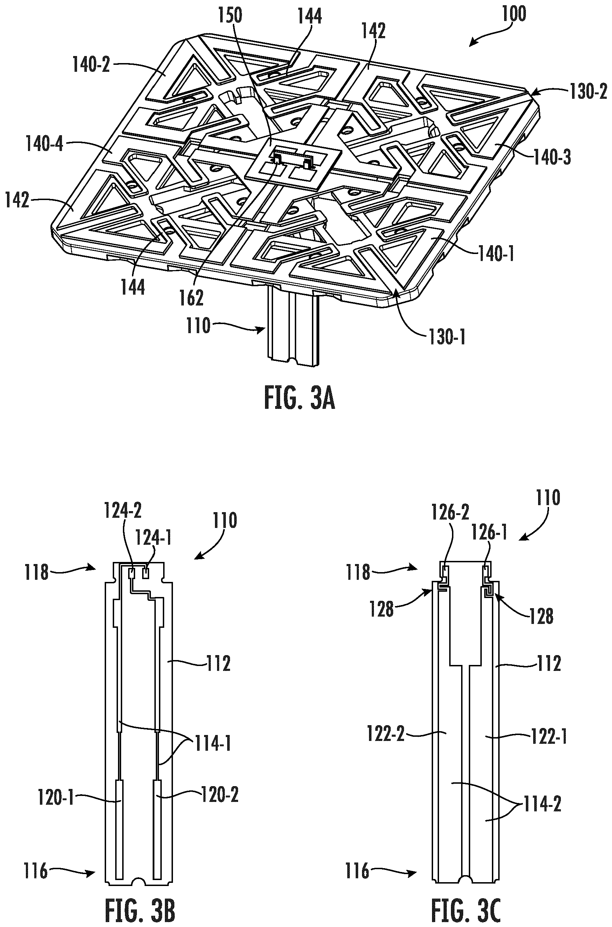

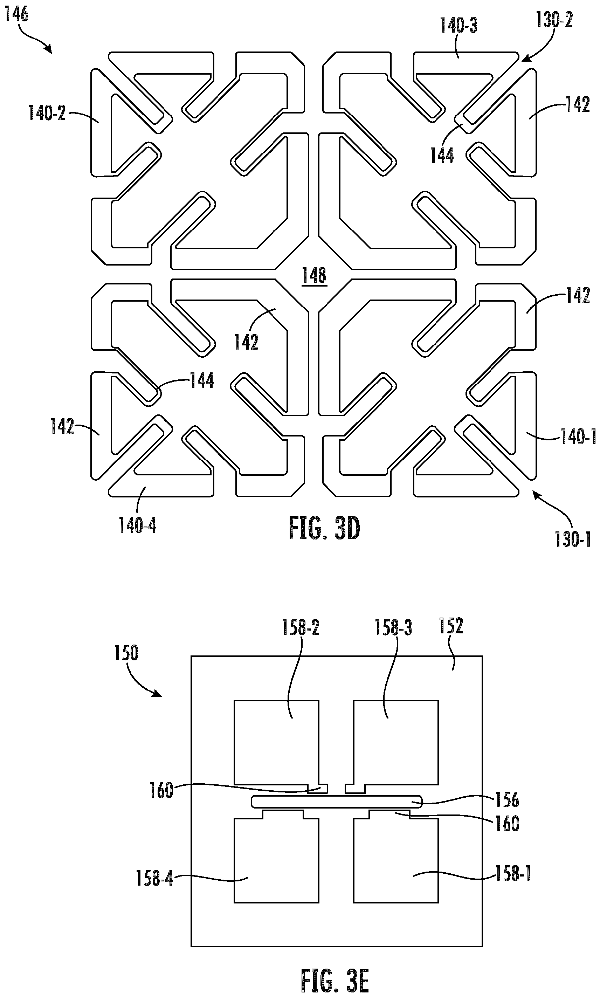

**FIGS. 3A-3E** illustrate a low cost, cloaked, cross-dipole low-band radiating element **100** according to embodiments of the present invention. In particular, **FIG. 3A** is a schematic front perspective view of the low-band radiating element **100.** **FIGS. 3B** and **3C** are side views illustrating the first and second major surfaces, respectively, of the feed stalk printed circuit board included in the radiating element **100.** **FIG. 3D** is a front view of the four dipole arms included in the radiating element **100.** Finally, **FIG. 3E** is a front view illustrating a first major surface of a coupling printed circuit board included in the radiating element **100.** The low-band radiating element **100** may, for example, be used in place of some or all of the low-band radiating elements **62** that are included in the base station antenna **40** of **FIGS. 2A-2B** to provide a base station antenna according to embodiments of the present invention. The base station antennas according to embodiments of the present invention may be used, for example, as sector base station antennas in the above-described base stations of a cellular communications network. As shown in **FIG. 3A****,** the low-band radiating element **100** includes a feed stalk printed circuit board **110,** first and second dipole radiators **130-1, 130-2,** a coupling printed circuit board **150,** and a dielectric support **170.**

Referring to **FIGS. 3B-3C****,** the feed stalk printed circuit board **110** comprises a single printed circuit board. The feed stalk printed circuit board **110** includes a dielectric substrate **112** that has a first metallization pattern **114-1 (****FIG. 3B****)** on a first major surface thereof and a second metallization pattern **114-2 (****FIG. 3C****)** on a second major surface thereof that is opposite the first major surface of the dielectric substrate **112.** The feed stalk printed circuit board **110** includes a base **116** that may be mounted, for example, on a feed board printed circuit board (not shown) and a distal end **118** that is opposite the base **116.**

The rear portions of the feed stalk printed circuit board **110** includes small rearwardly projecting tabs. These projecting tabs may be inserted through slits in a feedboard (e.g., one of the feedboards **64** of **FIG. 2B****)** in order to mount the radiating element **100** on the feedboard **64.** The feed stalk printed circuit board **110** includes first and second signal conductors **120-1, 120-2** and first and second ground conductors **122-1, 122-2.** The first signal conductor **120-1** overlaps the first ground conductor **122-1** and together the first signal conductor **120-1** and the first ground conductor **122-1** form a first feed line, which is in the form of a microstrip RF transmission line. The second signal conductor **120-2** similarly overlaps the second ground conductor **122-2** and together the second signal conductor **120-2** and the second ground conductor **122-2** form a second feed line, which is also in the form of a microstrip RF transmission line. Each rearwardly projecting tab may include a metallized portion and solder joints may be applied so that the first and second signal conductors **120-1, 120-2** are electrically connected to first and second signal traces of RF transmission lines on the feedboard **64** and so that the first and second ground conductors **122-1, 122-2** are electrically connected to first and second ground lines of RF transmission lines on the feedboard **64.** In this fashion the feed stalk printed circuit board **110** may be mechanically mounted on a feedboard **64** and a pair of RF transmission lines on the feedboard **64** may be electrically connected to the first and second feed lines **120-1/122-1; 120-2/122-2** that are provided on the feed stalk printed circuit board **110.** The radiating element **100** may be mounted to extend forwardly from the feedboard **64** with the feed stalk printed circuit board **110** extending perpendicularly to the feedboard **64.**

As shown in **FIGS. 3B-3C****,** the first and second signal conductors **120-1, 120-2** are part of the first metallization pattern **114-1** on the first major surface of the dielectric substrate **112.** Each signal conductor **120** is implemented as an elongated metal trace that extends from the base **116** to the distal end **118** of the feed stalk printed circuit board **110.** Each elongated trace has portions that have different widths. The widths may be selected so that the first and second feed lines **120-1/122-1; 120-2/122-2** that are provided on the feed stalk printed circuit board **110** will have a desired impedance. The distal ends of the traces that form the signal conductors **120** may be widened to form metal pads **124-1, 124-2.** The function of the metal pads **124** will be discussed below.

The first and second ground conductors **122-1, 122-2** are part of the second metallization pattern **114-2** on the second major surface of the dielectric substrate **112.** Each ground conductor **122** is implemented as a widened metal trace that extends from the base **116** to the distal end **118** of the feed stalk printed circuit board **110.** Forward portions of each widened trace may have smaller widths than the portions of the ground conductors **122** that are adjacent the base of the feed stalk printed circuit board **110.** The distal end of the traces that form the ground conductors **122** may be widened to form metal pads **126-1, 126-2.** The function of the metal pads **126** will be discussed below. In addition, each ground conductor **122** may include a section where the width of the ground conductor **122** is made small (e.g., no more than one-fourth the width of the widest part of the ground conductor **122)** to form a narrow trace section **128** that has increased inductance The narrow trace section **128** may be a meandered trace section. By meandering the trace, an inductance of the narrow trace section **128** may be further increased. Thus, each narrowed trace section **128** may form an inductor.

Referring to **FIGS. 3A** and **3D****,** the first dipole radiator **130-1** includes first and second sheet metal dipole arms **140-1, 140-2** that extend collinearly so that the first dipole radiator **130-1** will extend at an angle of -45° with respect to the horizon when the radiating element **100** is mounted for use in a base station antenna. The second dipole radiator **130-2** includes third and fourth sheet metal dipole arms **140-3, 140-4** that extend collinearly so that the second dipole radiator **130-2** will extend at an angle of +45° with respect to the horizon when the radiating element **100** is mounted for use in a base station antenna. The sheet metal dipole arms **140-1** and **140-2** of the first dipole radiator **130-1** transmit and receive signals having a slant -45° linear polarization, while the sheet metal dipole arms **140-3** and **140-4** of second dipole radiator **130-2** transmit and receive signals having a slant +45° linear polarization.

Each sheet metal dipole arm **140** has an outer perimeter that generally defines a square, although one corner of the square is beveled. The four sheet metal dipole arms **140** are positioned next to each other so that the outer perimeter of the combination of all four sheet metal dipole arms **140-1** through **140-4** defines a radiating surface **146** that has a generally square outer perimeter. The first and second inner sides of each sheet metal dipole arm **140** are adjacent inner sides of two others of the sheet metal dipole arms **140.** Adjacent dipole arms **140** are separated by a small gap so that the larger radiating surface **146** defined by the combination of all four sheet metal dipole arms **140** is more than four times larger than the smaller squares defined by the individual sheet metal dipole arms **140.**

Each sheet metal dipole arm **140** is a planar element, allowing the sheet metal dipole arms **140** to be formed through a stamping operation and without any additional bending operation. Each sheet metal dipole arm **140** may comprise a conductive loop that includes a plurality of wide sections **142** and a plurality of narrowed sections **144.** An average width of the wide sections **142** may be at least three times the average width of each narrowed section **144.** Every two adjacent wide sections **142** are connected through a narrowed section **144.** The widened sections **142** may capacitively couple with each other and the narrowed sections **144** may add inductance so that the sheet metal dipole arms **140** may have embedded LC circuits that may be tuned to pass lower frequency band currents while blocking higher frequency band currents. As a result, the sheet metal dipole arms **140** may readily transmit and receive RF signals in the low-band operating frequency range while being substantially transparent to RF energy in the mid-band and/or high-band operating frequency ranges. In other words, the low-band radiating element **100** may be cloaked with respect to mid-band and/or high-band RF radiation so that such radiation will not induce substantial currents on the low-band sheet metal dipole arms **140.**

As noted above, the outer perimeter of each sheet metal dipole arm **140** has a perimeter that generally defines a square, where one corner of the square is beveled. The sheet metal dipole arms **140** are positioned so that the beveled corner of each sheet metal dipole arm **140** is positioned in the center of the radiating surface **146,** forming an opening **148** therein. The distal end **118** of the feed stalk printed circuit board **110** may extend through the opening **148** so that the distal end **118** of the feed stalk printed circuit board **110** is positioned forwardly of the sheet metal dipole arms **140.**

Referring to **FIGS. 3A** and **3E****,** the coupling printed circuit board **150** is mounted on the distal end **118** of the feed stalk printed circuit board **110** forwardly of the dipole arms **140.** The coupling printed circuit board **150** includes a dielectric substrate **152** that has a metallization pattern **154** on a forward side thereof. A slot **156** is provided in the dielectric substrate **152.** The distal end **118** of the feed stalk printed circuit board **110** includes a tab that is inserted through the slot **156** to mechanically mount the coupling printed circuit board **150** on the feed stalk printed circuit board **110.** As shown in **FIG. 3E****,** the first metallization pattern **154** comprises four large metal pads **158-1** through **158-4.** Each large metal pad **158** may include a smaller metal pad **160** extending therefrom toward the slot **156.** As shown in **FIG. 3A****,** solder joints **162** are formed that electrically connect each small metal pad **160** on the coupling printed circuit board **150** to a respective one of the metal pads **124, 126** provided at the distal end **118** of the signal and ground conductors **120, 122.** The solder joints **162** galvanically connect the signal conductor **120-1** and ground conductor **122-1** of the first feed line **114-1** to metal pads **158-1, 158-2,** respectively, and galvanically connect the signal conductor **120-2** and ground conductor **122-2** of the second feed line **114-2** to metal pads **158-3, 158-4,** respectively.

Each large metal pad **158** overlaps a respective one of the dipole arms **140** in the forward direction (i.e., an axis extending in the forward direction will pass through each metal pad **158** and an associated one of the dipole arms **140).** Each metal pad **158** may overlap one of the wide sections **142** of a respective one of the dipole arms **140** so that each metal pad **158** and the wide section **142** form a capacitive connection ("capacitor"), with the dielectric substrate **152** of the coupling printed circuit board **150** serving as the dielectrics of these capacitors. Thus, each conductor of the feed lines **114** is capacitively coupled to a respective one of the dipole arms **140.**

As discussed above, each ground conductor **122** on the feed stalk printed circuit board **110** includes an inductor **128,** and the signal conductors **120** on the feed stalk printed circuit board **110** include narrow sections that also add inductance. Since the connection between each signal or ground conductor **120, 122** and their associated dipole arms **140** also includes the above-described capacitive connections, As such, a plurality of LC circuits are provided along the connections between each signal or ground conductor **120, 122** and their associated dipole arms **140.** These LC circuits may be tuned by adjusting the actual and relative amounts of capacitance and inductance thereof to improve the impedance match between the feed lines on the feed stalk printed circuit board **110** and the dipole arms **140.**

As noted above, the feed stalk of radiating element **100** is implemented using a single, relatively small feed stalk printed circuit board **110** that includes narrow signal conductors **120.** This may decrease the degree to which the feed stalk printed circuit board **110** causes the first (reflective) type of scattering discussed above. Moreover, scattering due to reflection is particularly problematic in multiband base station antennas that include multi-column beamforming arrays that are capable of scanning the generated antenna beams in the azimuth plane, as when the antenna beams are scanned the RF energy may intersect the feed stalk printed circuit boards of the low-band radiating elements at much smaller incident angles, which can result in much greater amounts of reflection. With radiating element **100,** the single feed stalk printed circuit board **110** may be oriented in the transverse direction of the base station antenna in which it is mounted so that when the antenna beams of the beamforming array are scanned in the azimuth plane they intersect the thin side surface of the feed stalk printed circuit board **110,** which results in far less reflection.

Referring again to **FIG. 3A****,** the dielectric support **170** may comprise a plastic support that is mounted, for example, directly behind the dipole arms **140.** Rivets or other fasteners (not shown) may be used to mount the dipole arms **140** on the dielectric support **170,** although it will be appreciated that any suitable mounting mechanism may be used (including capturing the dipole arms between two dielectric support pieces). While not shown, the dielectric support **170** may include one or more rearwardly extending legs that are used, for example, to mount the dielectric support on a reflector of the base station antenna. The dielectric support **170** may ensure that the dipole arms **140** remain in fixed positions. The dielectric support **170** may include a plurality of cut-outs to reduce the weight thereof and the extent to which the dielectric support **170** impacts the RF performance of radiating element **100.**

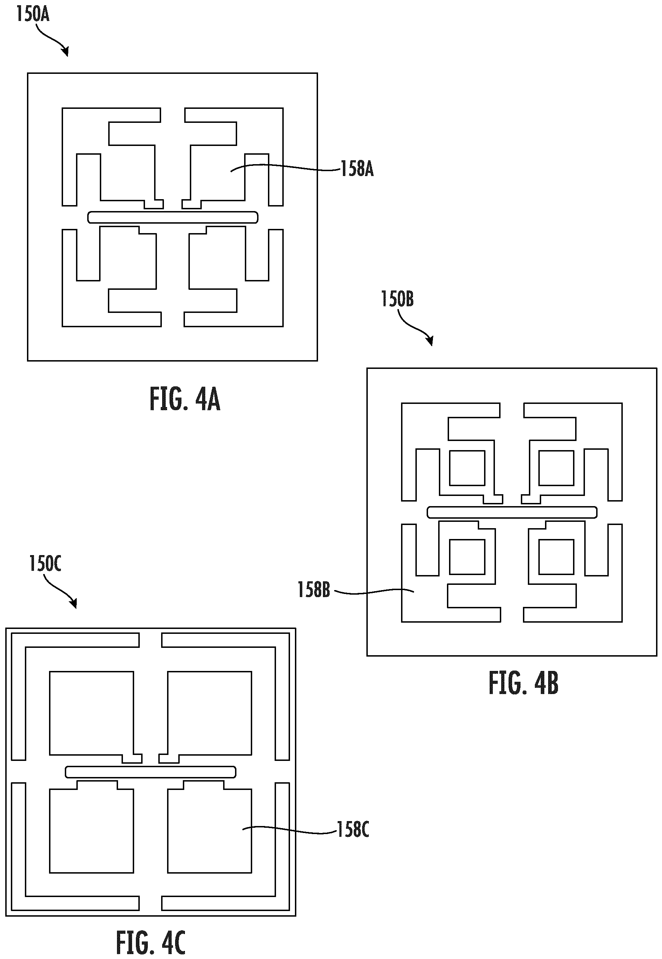

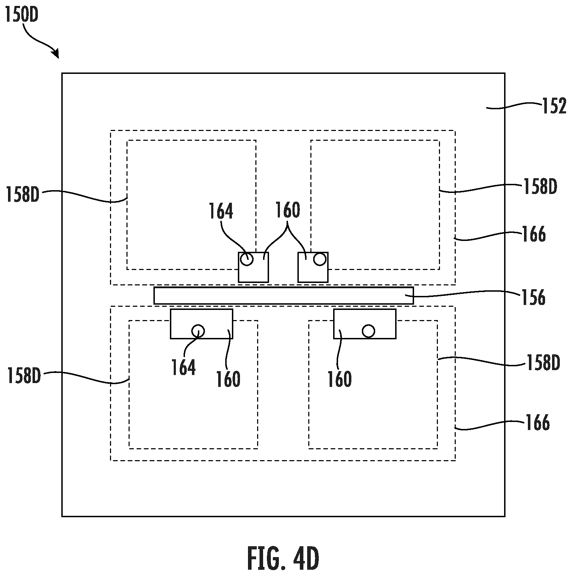

It will be appreciated that many different coupling printed circuit board designs may be used. **FIGS. 4A-4C** illustrate three alternative coupling printed circuit boards **150A-150C** that may be used in place of coupling printed circuit board **150.** Coupling printed circuit boards **150A-150C** include different metal pad designs **158A-158C.** It will also be appreciated that the metal pads may be formed on the rear surface of a coupling printed circuit board instead of the front surface. For example, **FIG. 4D** is a shadow front view of a coupling printed circuit board **150D** that includes small pads **160** on a forward surface of dielectric substrate **152** that can be connected to the respective signal and ground conductors **120, 122** on the feed stalk printed circuit board **110.** The small pads **160** are connected to metal pads **158D** that are formed on the rear surface of dielectric substrate **152** via plated through holes **164** that extend through the dielectric substrate **152.** A solder mask **166** may be formed over metal pads **158D** so that the metal pads **158D** capacitively couple with the respective dipole arms **240-1** through **240-4.** Since the solder mask **166** may typically be much thinner than the dielectric substrate **152,** increased capacitive coupling may be obtained using coupling printed circuit board **150D.** This may allow using a smaller coupling printed circuit board.

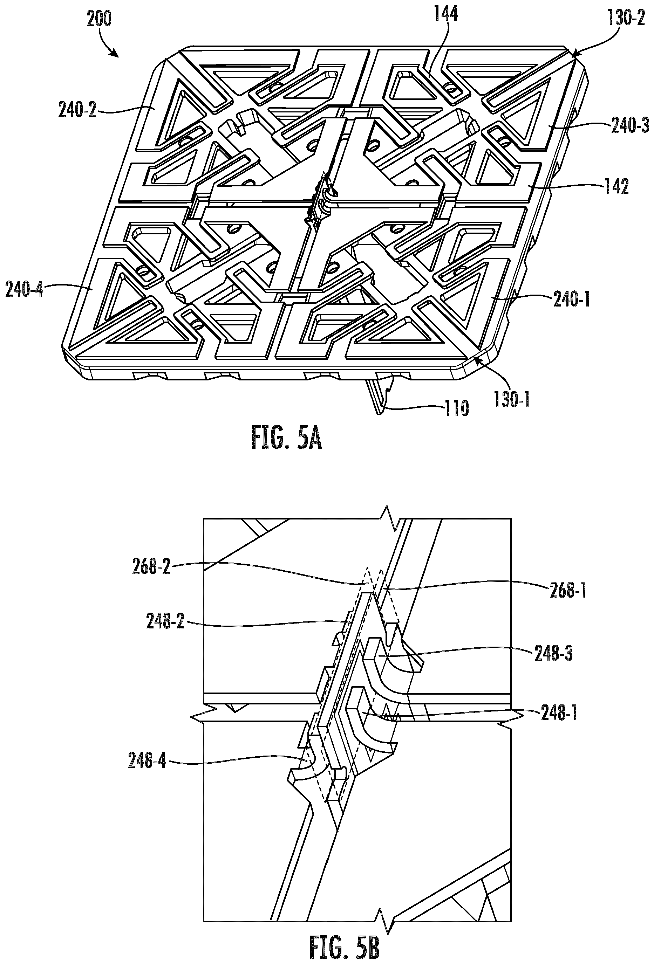

**FIGS. 5A** and **5B** illustrate a low-band radiating element **200** according to further embodiments of the present invention. In particular, **FIG. 5A** is a front perspective view of a low-band radiating element according to further embodiments of the present invention, and **FIG. 5B** is an enlarged perspective front view of the electrical connections between the feed stalk printed circuit board and dipole arms of the low-band radiating element of **FIG. 5A****.** The radiating element **200** is similar to radiating element **100,** and hence the description below focuses on the differences between the two radiating elements **100, 200.** Elements of radiating element **200** that are identical or essentially identical to corresponding elements of radiating element **100** are identified using the same reference numerals used in the description of radiating element **100** and further description of these elements will typically be omitted in the description of radiating element **200** below.

Referring first to **FIG. 5A****,** it can be seen that radiating element **200** includes a feed stalk printed circuit board **110** which may be identical to feed stalk printed circuit board **110** of **FIGS. 3B-3C****,** first through fourth dipole arms **240-1** through **240-4,** and a dielectric support **170** which may be similar or identical to the dielectric support **170** shown in **FIG. 3A****.** Notably, radiating element **200** does not include a coupling printed circuit board.

Referring to **FIG. 5B****,** the primary difference between radiating elements **100** and **200** is that in radiating element **200** the dipole arms **240-1** through **240-4** are "directly" capacitively coupled to the respective signal and ground conductors **120, 122** on the feed stalk printed circuit board **110.** This approach not only eliminates any need for a coupling printed circuit board, thereby reducing the part count and cost, it also eliminates any need for solder joints along the electrical paths from the respective signal and ground conductors **120, 122** on the feed stalk printed circuit board **110** to the dipole arms **240-1** through **240-4.** The elimination of these solder joints simplifies the manufacturing process and eliminates a potential source of passive intermodulation ("PIM") distortion (as poorly formed solder joints are a well-known PIM distortion source. Radiating element **200,** however, may require additional dielectric members to ensure consistent capacitive connections between the dipole arms **240** and the signal and ground conductors **120, 122** on the feed stalk printed circuit board **110.**

As can best be seen in **FIG. 5B****,** the dipole arms **240** do not include an inner beveled corner, and each dipole arm **240** further includes a forwardly-extending tab **248** (some or all of the tabs **248** could alternatively be rearwardly-extending tabs or laterally-extending tabs) that extends from the inner corner of each dipole arm **240.** Each tab **248** extends generally parallel to the feed stalk printed circuit board **110** and overlaps a respective one of the signal or ground conductors **120, 122** on the feed stalk printed circuit board **110.** A first solder mask **268-1** is formed on the first surface of the feed stalk printed circuit board **110** and a second solder mask **268-2** is formed on the second surface of the feed stalk printed circuit board **110.** The first solder mask **268-1** is interposed in between the first tab **248-1** and the first signal conductor **120-1,** and in between the third tab **248-3** and the second signal conductor **120-2.** The second solder mask **268-2** is interposed in between the second tab **248-2** and the first ground conductor **122-1,** and in between the fourth tab **248-4** and the second ground conductor **122-2.** The first and second solder masks **268-1, 268-2** thus act as the dielectric between the four capacitive connections between the signal and ground conductors **120, 122** and the respective four dipole arms **240-1** through **240-4.**

Referring to both **FIGS. 3A-3E** and **5A-5B,** it can be seen that pursuant to some embodiments of the present invention, radiating elements **100, 200** are provided comprise a dielectric support **170,** first through fourth sheet metal dipole arms **140-1-140-4** or **240-1, 240-2** on the dielectric support **170,** and a feed stalk printed circuit board **110.** The feed stalk printed circuit board **110** includes a first RF transmission line that has a first signal conductor **120-1** that is coupled to the first sheet metal dipole arm **140-1; 240-2** through at least a first capacitive connection and a first ground conductor **122-1** that is coupled to the second sheet metal dipole arm **140-2; 240-2** through at least a second capacitive connection, and a second RF transmission line that has a second signal conductor **120-2** that is coupled to the third sheet metal dipole arm **140-3; 240-3** through at least a third capacitive connection and a second ground conductor **122-2** that is coupled to the fourth sheet metal dipole arm **140-4; 240-4** through at least a fourth capacitive connection.

In some embodiments, the radiating element **100** comprises a coupling printed circuit board **150** that is mounted on the feed stalk printed circuit board **110.** This coupling printed circuit board **150** may include a first metal pad **158-1** that is electrically connected to the first signal conductor **120-1** through a first galvanic connection, a second metal pad **158-2** that is electrically connected to the first ground conductor **122-1** through a second galvanic connection, a third metal pad **158-3** that is electrically connected to the second signal conductor **120-2** through a third galvanic connection, and a fourth metal pad **158-4** that is electrically connected to the second ground conductor **122-2** through a fourth galvanic connection. In such embodiments, the first metal pad **158-1** may be capacitively coupled to the first sheet metal dipole arm **140-1,** the second metal pad **158-1** may be capacitively coupled to the second sheet metal dipole arm **140-2,** the third metal pad **158-3** may be capacitively coupled to the third sheet metal dipole arm **140-3,** and the fourth metal pad **158-4** may be capacitively coupled to the fourth sheet metal dipole arm **140-4.** The base **116** of the feed stalk printed circuit board **110** may be positioned rearwardly of the sheet metal dipole arms **140** and the coupling printed circuit board **150** may be positioned forwardly of the sheet metal dipole arms **140.** For example, the sheet metal dipole arms **140** may be positioned in between the dielectric support **170** and the coupling printed circuit board **150.** In some embodiments, the metal pads **158** may be on a forward surface of a dielectric substrate **152** of the coupling printed circuit board **150.**

A distal end **118** of the feed stalk printed circuit board **110** that is opposite the base **116** may extend through a slot **156** in the coupling printed circuit board **150.** Each of the first through fourth sheet metal dipole arms **140** may be positioned adjacent two other of the first through fourth sheet metal dipole arms **140** so that together the first through fourth sheet metal dipole arms **140** form a radiating surface **146** that has a square perimeter. The feed stalk printed circuit board **110** may extend through an opening **148** in the center of the radiating surface **146.**

In these embodiments, the first ground conductor **122-1** may include a first meandered trace segment **128** and the second ground conductor **122-2** may include a second meandered trace segment **128.** The first meandered trace segment **128** and the second capacitive connection together form a first LC circuit that increases an impedance of the first RF transmission line on the feed stalk printed circuit board **110,** and the second meandered trace segment **110** and the fourth capacitive connection together form a second LC circuit that increases an impedance of the second RF transmission line on the feed stalk printed circuit board **110.** The first signal conductor **120-1** may be coupled to the first sheet metal dipole arm **140-1** through both a solder joint and the first capacitive connection

In other embodiments, the coupling printed circuit board **150** may be omitted. For example, in radiating element **200** the first sheet metal dipole arm **240-1** may include a first tab **248-1** that extends parallel to the feed stalk printed circuit board **110** and is configured to capacitively couple with the first signal conductor **120-1** to form the first capacitive connection, the second sheet metal dipole arm **240-2** may include a second tab **248-2** that extends parallel to the feed stalk printed circuit board **110** and is configured to capacitively couple with the first ground conductor **122-1** to form the second capacitive connection, the third sheet metal dipole arm **240-3** may include a third tab **248-3** that extends parallel to the feed stalk printed circuit board **110** and is configured to capacitively couple with the second signal conductor **120-2** to form the third capacitive connection, and the fourth sheet metal dipole arm **240-4** may include a fourth tab **248-4** that extends parallel to the feed stalk printed circuit board **110** and is configured to capacitively couple with the second ground conductor **122-2** to form the fourth capacitive connection. In such embodiments, the radiating element **200** may further comprise a first solder mask **268-1** on a first side of the feed stalk printed circuit board **110** that is positioned between the first tab **248-1** and the first signal conductor **120-1** and a second solder mask **268-2** on a second side of the feed stalk printed circuit board **110** that is positioned between the second tab **248-2** and the first ground conductor **122-1.**

Referring to **FIGS. 3A-3E****,** pursuant to further embodiments of the present invention, radiating elements **100** are provided that comprise a plurality of sheet metal dipole arms **140,** a feed stalk printed circuit board **110,** and a coupling printed circuit board **150** that is mounted on the feed stalk printed circuit board **110** and configured to capacitively couple RF signals between the feed stalk printed circuit board **110** and the sheet metal dipole arms **140.**

Referring to **FIGS. 5A-5B****,** pursuant to further embodiments of the present invention, radiating elements **200** are provided that comprise a dielectric support **170,** first and second sheet metal dipole arms **240-1, 240-2** on the dielectric support **170,** and a feed stalk printed circuit board **110** that includes a first RF transmission line that has a first signal conductor **120-1** and a first ground conductor **122-1.** The first sheet metal dipole arm **240-1** includes a first tab **248-1** that is configured to capacitively couple with the first signal conductor **120-1** and the second sheet metal dipole arm **240-2** includes a second tab **248-2** is configured to capacitively couple with the first ground conductor **122-2.** The first and second tabs **248-1, 248-2** may extend parallel to the feed stalk printed circuit board **110.** A first solder mask **268-1** may be formed on a first side of the feed stalk printed circuit board **110** and positioned between the first tab **248-1** and the first signal conductor **120-1,** and a second solder mask **268-2** may be formed on a second side of the feed stalk printed circuit board **110** and positioned between the second tab **248-2** and the first ground conductor **122-1.**

It will be appreciated that many modifications may be made to the above-described low-cost radiating elements without departing from the scope of the present invention. As one example, the feed stalk printed circuit boards may include cloaked RF transmission lines as disclosed, for example, in PCT Patent Application Serial Nos. PCT/CN23/070056 and PCT/US24/10094, the entire content of each of which is hereby incorporated herein by reference. As another example, the coupling printed circuit board **150** may be mounted rearwardly of the dipole arms **140** in other embodiments. The dipole arms **140, 240** may include any suitable cloaking design. Any suitable dielectric substrate **170** may be used, and the dielectric substrate may be omitted in some embodiments, particularly if the dipole arms **140, 240** are sufficiently rigid. Different feed stalk printed circuit boards may be used, and in some cases two feed stalk printed circuit boards may be used. Finally, while radiating elements **100, 200** are low-band radiating elements, it will be appreciated that they can be scaled in size and turned into mid-band or high-band radiating elements in other embodiments.

Pursuant to some aspects of the present invention, a radiating element is provided that comprises a plurality of sheet metal dipole arms; a feed stalk printed circuit board; and a coupling printed circuit board that is mounted on the feed stalk printed circuit board and configured to capacitively couple RF signals between the feed stalk printed circuit board and the sheet metal dipole arms. In some embodiments, a base of the feed stalk printed circuit board is positioned rearwardly of the dipole arms and the coupling printed circuit board is positioned forwardly of the dipole arms. In some embodiments, the first and second conductors of a first RF transmission line of the feed stalk printed circuit board are galvanically connected to respective first and second metal pads on the coupling printed circuit board. The first and second metal pads may, for example, be on a forward surface of a dielectric substrate of the coupling printed circuit board. Additionally, the first RF transmission line of the feed stalk printed circuit board may (but need not) include a meandered trace segment. If a meandered trace segment is provided, a capacitive connection between the first metal pad on the coupling printed circuit board and a first of the dipole arms together form a capacitor-inductor circuit that increases an impedance of the first RF transmission line.

In some embodiments, the feed stalk printed circuit board may comprise a first RF transmission line that is coupled to first and second of the sheet metal dipole arms and a second RF transmission line that is coupled to third and fourth of the sheet metal dipole arms. In such embodiments, the coupling printed circuit board may include a first metal pad that is galvanically connected to a signal conductor of the first RF transmission line, a second metal pad that is galvanically connected to a ground conductor of the first RF transmission line, a third metal pad that is galvanically connected to a signal conductor of the second RF transmission line, and a fourth metal pad that is galvanically connected to a ground conductor of the second RF transmission line. In addition, the plurality of sheet metal dipole arms may comprise first through fourth sheet metal dipole arms, and the first through fourth metal pads may be capacitively coupled to respective ones of first through fourth sheet metal dipole arms.

In any of the above-discussed embodiments, the feed stalk printed circuit board may include at least one tab that extends through a slot in the coupling printed circuit board.

Pursuant to additional aspects of the present invention, a radiating element is provided that comprises a dielectric support; a first sheet metal dipole arm on the dielectric support; a second sheet metal dipole arm on the dielectric support; and a feed stalk printed circuit board that includes a first RF transmission line that includes a first signal conductor and a first ground conductor. The first sheet metal dipole arm includes a first tab that is configured to capacitively couple with the first signal conductor and the second sheet metal dipole arm includes a second tab is configured to capacitively couple with the first ground conductor.

In some embodiments, the first and second tabs may extend parallel to the feed stalk printed circuit board. Additionally or alternatively, the radiating element may further comprise a first solder mask on a first side of the feed stalk printed circuit board that is positioned between the first tab and the first signal conductor and a second solder mask on a second side of the feed stalk printed circuit board that is positioned between the second tab and the first ground conductor. The feed stalk printed circuit board may further include a second RF transmission line that includes a second signal conductor and a second ground conductor, and the radiating element further comprises a third sheet metal dipole arm and a fourth sheet metal dipole arm. In such embodiments, the third sheet metal dipole arm may include a third tab that extends parallel to the feed stalk printed circuit board and is configured to capacitively couple with the second signal conductor and the fourth sheet metal dipole arm may include a fourth tab that extends parallel to the feed stalk printed circuit board and is configured to capacitively couple with the second ground conductor. The first solder mask may be positioned between the third tab and the second signal conductor and the second solder mask may be positioned between the fourth tab and the second ground conductor.

In any of the above-discussed embodiments, the first RF transmission line may include a meandered trace segment. In such embodiments, the meandered trace segment and a capacitive connection between the first pad and the first signal conductor together form a capacitor-inductor circuit that increases an impedance of the first RF transmission line.

Embodiments of the present invention have been described above with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

It will be understood that when an element is referred to as being "on" another element, it can be directly on the other element or intervening elements may also be present. In contrast, when an element is referred to as being "directly on" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (*i.e.,* "between" versus "directly between", "adjacent" versus "directly adjacent", etc.).

Relative terms such as "below" or "above" or "upper" or "lower" or "horizontal" or "vertical" may be used herein to describe a relationship of one element, layer or region to another element, layer or region as illustrated in the figures. It will be understood that these terms are intended to encompass different orientations of the device in addition to the orientation depicted in the figures.

Herein, the term "substantially" means within +/- 10%.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" "comprising," "includes" and/or "including" when used herein, specify the presence of stated features, operations, elements, and/or components, but do not preclude the presence or addition of one or more other features, operations, elements, components, and/or groups thereof.

Aspects and elements of all of the embodiments disclosed above can be combined in any way and/or combination with aspects or elements of other embodiments to provide a plurality of additional embodiments.

## Claims

1. A radiating element, comprising:
a dielectric support;
first through fourth sheet metal dipole arms on the dielectric support; and
a feed stalk printed circuit board that includes:
a first radio frequency ("RF") transmission line that has a first signal conductor that is coupled to the first sheet metal dipole arm through at least a first capacitive connection and a first ground conductor that is coupled to the second sheet metal dipole arm through at least a second capacitive connection; and
a second RF transmission line that has a second signal conductor that is coupled to the third sheet metal dipole arm through at least a third capacitive connection and a second ground conductor that is coupled to the fourth sheet metal dipole arm through at least a fourth capacitive connection.

2. The radiating element of Claim 1, further comprising a coupling printed circuit board that is mounted on the feed stalk printed circuit board, the coupling printed circuit board including a first metal pad that is electrically connected to the first signal conductor through a first galvanic connection, a second metal pad that is electrically connected to the first ground conductor through a second galvanic connection, a third metal pad that is electrically connected to the second signal conductor through a third galvanic connection, and a fourth metal pad that is electrically connected to the second ground conductor through a fourth galvanic connection.

3. The radiating element of Claim 2, wherein the first metal pad is capacitively coupled to the first sheet metal dipole arm, the second metal pad is capacitively coupled to the second sheet metal dipole arm, the third metal pad is capacitively coupled to the third sheet metal dipole arm, and the fourth metal pad is capacitively coupled to the fourth sheet metal dipole arm.

4. The radiating element of Claim 3, wherein a base of the feed stalk printed circuit board that is remote from the dipole arms is positioned rearwardly of the first through fourth sheet metal dipole arms and the coupling printed circuit board is positioned forwardly of the first through fourth sheet metal dipole arms.

5. The radiating element of any of Claims 2-4, wherein the first through fourth sheet metal dipole arms are positioned in between the dielectric support and the coupling printed circuit board.

6. The radiating element of Claim 5, wherein the first through fourth metal pads are on a forward surface of a dielectric substrate of the coupling printed circuit board.

7. The radiating element of any of Claims 1-6, wherein the first ground conductor includes a first meandered trace segment and the second ground conductor includes a second meandered trace segment.

8. The radiating element of Claim 7, wherein the first meandered trace segment and the second capacitive connection together form a first capacitor-inductor circuit that increases an impedance of the first RF transmission line, and the second meandered trace segment and the fourth capacitive connection together form a second capacitor-inductor circuit that increases an impedance of the second RF transmission line.

9. The radiating element of any of Claims 2-8, wherein a distal end of the feed stalk printed circuit board that is opposite the base extends through a slot in the coupling printed circuit board.

10. The radiating element of any of Claims 1-9, wherein each of the first through fourth sheet metal dipole arms is positioned adjacent two other of the first through fourth sheet metal dipole arms so that together the first through fourth sheet metal dipole arms form a radiating surface that has a square perimeter.

11. The radiating element of any of Claims 1-10, wherein the feed stalk printed circuit board extends through an opening in the center of the radiating surface.

12. The radiating element of any of Claims 1-11, wherein the first signal conductor is coupled to the first sheet metal dipole arm through both a solder joint and the first capacitive connection.

13. The radiating element of any of Claims 1-12, wherein the first sheet metal dipole arm includes a first tab that extends parallel to the feed stalk printed circuit board and is configured to capacitively couple with the first signal conductor to form the first capacitive connection, the second sheet metal dipole arm includes a second tab that extends parallel to the feed stalk printed circuit board and is configured to capacitively couple with the first ground conductor to form the second capacitive connection, the third sheet metal dipole arm includes a third tab that extends parallel to the feed stalk printed circuit board and is configured to capacitively couple with the second signal conductor to form the third capacitive connection, and the fourth sheet metal dipole arm includes a fourth tab that extends parallel to the feed stalk printed circuit board and is configured to capacitively couple with the second ground conductor to form the fourth capacitive connection.

14. The radiating element of Claim 13, further comprising a first solder mask on a first side of the feed stalk printed circuit board that is positioned between the first tab and the first signal conductor and a second solder mask on a second side of the feed stalk printed circuit board that is positioned between the second tab and the first ground conductor.

15. The radiating element of Claim 14, wherein one of the first and second solder masks is also positioned between the third tab and the second signal conductor and the other of the first and second solder masks is positioned between the fourth tab and the second ground conductor.
